(19) Europäisches Patentamt / European Patent Office / Office européen des brevets

(11) **EP 1 731 305 B1**

(12) **EUROPEAN PATENT SPECIFICATION**

(45) Date of publication and mention
of the grant of the patent:
**12.03.2008 Bulletin 2008/11**

(51) Int Cl.:
***B32B 27/36*** *(2006.01)*    ***B32B 27/30*** *(2006.01)*
***H01L 41/26*** *(2006.01)*

(21) Application number: **05012421.3**

(22) Date of filing: **09.06.2005**

(54) **Laminated film, polyvinylidene fluoride thin film, electronic component and method of manufacturing same**

Mehrschichtfolie, dünne Schicht aus Polyvinylidenfluorid, Elektronisches Bauteil und Verfahren zu seiner Herstellung

Film laminé, couche mince en poly(fluorure de vinylidène), composant électronique et procédé pour sa fabrication

(84) Designated Contracting States:
**AT BE BG CH CY CZ DE DK EE ES FI FR GB GR HU IE IS IT LI LT LU MC NL PL PT RO SE SI SK TR**

(43) Date of publication of application:
**13.12.2006 Bulletin 2006/50**

(73) Proprietors:
• **Kureha Corporation**
  **Tokyo 103-8552 (JP)**
• **Kureha Extech Co., Ltd.**
  **Kasumigaura-city**
  **Ibaraki 300-0121 (JP)**

(72) Inventors:
• **Hayashi, Eiichi**
  **Kasumigaura-city**
  **Ibaraki 300-0121 (JP)**
• **Suzuki, Keiichiro,**
  **c/o Kureha Chem. Ind. Comp. Ltd**
  **Tokyo 103-8552 (JP)**

(74) Representative: **HOFFMANN EITLE**
**Patent- und Rechtsanwälte**
**Arabellastrasse 4**
**81925 München (DE)**

(56) References cited:
**US-A- 4 302 408**

**Description**

BACKGROUND OF THE INVENTION

Field of the Invention

The present invention relates to a laminated film, a polyvinylidene fluoride thin film, an electronic component and a method of manufacturing same.

Related Background of the Invention

Polyvinylidene fluoride has a high dielectric constant, and has high piezoelectric properties and pyroelectric properties. It is therefore expected to have application in electronic components such as electrical capacitor elements, piezoelectric elements or pyroelectric elements, and thin polyvinylidene fluoride films are attracting special interest.

As for methods of manufacturing these vinylidene fluoride thin films, a resin different from polyvinylidene fluoride can for example be adhesion-laminated on one surface of a unoriented polyvinylidene fluoride material by dry lamination or die lamination to prepare a unoriented adhesion laminate (laminated film), and the laminated film then extended to obtain an extended polyvinylidene fluoride thin film having a thickness of 7μm or less. This laminated film may be for example a laminate of polyvinylidene fluoride and nylon, or a laminate of polyvinylidene fluoride and polypropylene. In addition to lamination, this laminated material may be manufactured by casting a polyvinylidene fluoride solution on a resin thin film, and drying (e.g., Japanese Examined Patent Publication No. SHO 60-6220, Japanese Unexamined Patent Publication No. SHO 60-54832, Japanese Unexamined Patent Publication No. SHO 57-156224, Japanese Unexamined Patent Publication No. SHO 61-123520, Japanese Unexamined Patent Publication No. HEI 01-198636, Japanese Unexamined Patent Publication No. SHO 63-243143).

US 4302408 discloses the preparation of thin PVDF films via intermediate lamination to another resin layer.

SUMMARY OF THE INVENTION

However, in laminated films of polyvinylidene fluoride and nylon, since nylon is very hygroscopic, curl tends to occur due to the effect of moisture but the direction of curl is not determined. On the other hand, in laminated films of polyvinylidene fluoride and polypropylene, although polypropylene has excellent resistance to moisture absorption, it has poor resistance to heat and becomes semi-molten (with wrinkling and sticking) when heated, so it cannot function as a substrate. Also, in the aforesaid solution casting method, the manufacturing steps are complex and curl suppression of the polyvinylidene fluoride thin film is inadequate. Therefore, a polyvinylidene fluoride thin film having suppressed curl was desired.

It is therefore an object of the present invention, which was conceived in view of the aforesaid problems, to provide a laminated film for obtaining a polyvinylidene fluoride thin film suitable for use in electronic components which is easy to handle, which has excellent dimensional stability and heat resistance, and which is also transparent, glossy, non-hygroscopic and non-curling. It is a further object of the present invention to provide a method of manufacturing a polyvinylidene fluoride thin film which can be obtained by peeling away from this laminated film, an electronic component comprising this polyvinylidene fluoride thin film, and a method of manufacturing same.

The Inventors, as a result of detailed studies carried out to resolve the aforesaid problems, discovered that by using a combination of polybutylene terephthalate and polyvinylidene fluoride to prepare a unoriented laminated film, and arranging the peel strength of the polybutylene terephthalate film and polyvinylidene fluoride film forming the laminated film so as to lie within a specified region, the aforesid problems could be resolved, and thereby arrived at the present invention.

Specifically, the laminated film of the present invention is formed by laminating a polyvinylidene fluoride thin film on a polybutylene terephthalate film such that it can be peeled away therefrom. The laminated film is unoriented, the peel strength of the polybutylene terephthalate film and the polyvinylidene fluoride film is within the range of 1-80g/25mm width for easy peeling, and the laminated film is easy to handle.

The Inventors made the following observations concerning the polyvinylidene fluoride thin film obtained by extending the laminated film. When the laminated film obtained by extrusion molding is extended, due to the fact that it is difficult to apply tensile force evenly to the whole film, wrinkles may form locally in the polyvinylidene fluoride thin film. Also, extended laminated films are often heat-fixed to suppress heat shrinkage, but even if they are heat-fixed, the dimensional stability of the polyvinylidene fluoride thin film may be insufficient during heating.

The Inventors made further observations regarding laminated films comprising polyethylene terephthalate and polyvinylidene fluoride. When amorphous polyethylene terephthalate is used as the polyethylene terephthalate, the heat resistance of the polyethylene terephthalate is insufficient, so the laminated film tends to curl. On the other hand, when crystalline polyethylene terephthalate is used, whitening occurs and a transparent laminated film cannot be obtained. On the other hand, both crystalline and amorphous polybutylene terephthalate have sufficient heat resistance and are non-hygroscopic, so curl of the laminated film can be suppressed, and curl of the polyvinylidene fluoride thin film also does not occur so easily. From these observations, the Inventors succeeded in resolving the above problems by manufacturing a unoriented laminated film using polybutylene terephthalate and polyvinylidene fluoride as the laminated film materials.

In the context of the present invention, peel strength means the tensile force between the polybutylene terephthalate film and polyvinylidene fluoride film when a sample piece cut to a width of 25mm from a laminated film based on JIS K6854 is subjected to a T type peeling test at a tensile velocity of $100\pm5$mm/min.

The elastic moduli in the length and width directions before and after heating the laminated film which are derived from the following equation (1), are preferably respectively -2 to +2%, but a smaller elastic modulus may be desired depending on the dimensional precision of the electronic components.

$$S(\%)=(L_2-L_1)/L_1 \times 100$$

[in the equation, S is the elastic modulus, and $L_1$ is 100mm which is the distance (mm) between reference points prior to heating. $L_2$ is the distance (mm) between reference points after heating at $100\pm2$°C for 10 mins.

By arranging the elastic moduli in the length and width directions of the laminated film to lie within the aforesaid range, heat curl can be sufficiently suppressed, and a polyvinylidene fluoride thin film having excellent dimensional stability can be obtained. The elastic modulus may be obtained by cutting out a square test piece of 120mm side from a laminated, unoriented film, measuring the distance between reference points in the length direction (MD) and width direction (TD) of the laminated film after heating, and substituting this measured value in the aforesaid equation (1) based on JIS K6734, 6.6.

The invention further provides a polyvinylidene fluoride film obtained by peeling away from the aforesaid laminated film of the invention. As the laminated film of the invention can be peeled away, the polyvinylidene fluoride thin film can be easily obtained.

The invention further provides a method of manufacturing a polyvinylidene fluoride thin film wherein molten polybutylene terephthalate and polyvinylidene fluoride are co-extruded to obtain a unoriented film which is laminated such that the polyvinylidene fluoride thin film on the polybutylene terephthalate film can be peeled away, and the polybutylene terephthalate film is then peeled away from the aforesaid laminated unoriented film.

The invention further provides an electronic component comprising a substrate, a unoriented film layer laminated on one of the main surface of the substrate and plural electrodes formed at a predetermined interval on the other main surface of the substrate, wherein the aforesaid film layer is a polyvinylidene fluoride thin film according to the present invention.

Since the electronic component of the present invention comprises the polyvinylidene fluoride thin film, an electronic component having a large electrostatic capacity and excellent sensitivity can be provided. Also, since polyvinylidene fluoride has excellent water resistance and soiling resistance, the electronic component has excellent water resistance and soiling resistance. Here, the predetermined interval between electrodes depends on the construction of the electronic component, and refers to the electrode interval at which the function of the electronic component is obtained. For example, if the electronic component is an EL light-emitting element, this refers to the electrode interval at which a light-emitting body with which the EL light-emitting element is provided can radiate light.

The invention further provides a method of manufacturing an electronic component comprising a substrate, a unoriented film layer laminated on one of the main surface of the substrate and plural electrodes formed at a predetermined interval on the other main surface of the substrate, comprising the steps of forming a substrate so that one of the main surfaces to be formed comes in contact with the polyvinylidene fluoride thin film on the laminated film of the present invention, forming plural electrodes on the other main surface of the substrate, and peeling a polybutylene terephthalate film away from the laminated film on which the substrate and electrodes were formed.

BRIEF DESCRIPTION OF THE DRAWINGS

FIG. 1 is a cross-sectional view showing the laminated film according to the present embodiment of the invention.
FIG. 2 is a schematic view showing one example of a manufacturing device which can be applied to a method of manufacturing the laminated film according to the present embodiment of the invention.
FIG. 3 is a cross-sectional view showing an electronic component according to the present embodiment of the invention.

## DESCRIPTION OF THE PREFERRED EMBODIMENTS

The present invention will now be described in detail referring to specific examples of the laminated film according to the invention, and an electronic component wherein a substrate and electrodes are mounted on this film. In the description of the drawings, identical elements are assigned identical symbols and their description is not repeated. Dimensional ratios in the drawings are given for convenience and do not necessarily coincide with those in the description.

(Laminated film)

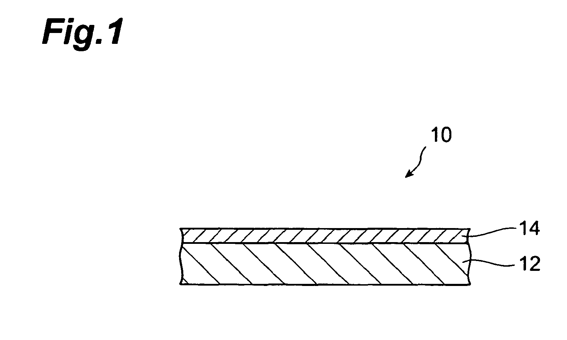

FIG. 1 is a cross-sectional view of a laminated film according to the present embodiment of the invention. A laminated film 10 according to the present embodiment comprises a polybutylene terephthalate (hereafter, "PBT") film 12 and a polyvinylidene fluoride (hereafter, "PVDF") thin film 14. The PVDF film 14 is formed on the PBT film 12.

The PBT film 12 is peeled off when the laminated film 10 is used as a part of an electronic component, described later, and functions as a support for the PVDF film 14. The PBT may not only be PBT having a high degree of crystallinity, but also PBT degree of crystallinity whereof the reduced by controlling the cooling method during manufacture of the PBT. PBT has a low water absorption coefficient, and as it also has excellent heat resistance, it is not much affected by moisture or heat during manufacture, storage or use of the laminated film 10. Therefore, in the laminated film 10 comprising the PBT film 12 having these properties, curl is suppressed. The PBT may be idcentical to the substance known in the art and preferably has a polymerization degree of 50-400, e.g., Gelanex 500FP or Gelanex 700FP (commercial names, Polyplastics Ltd.).

The thickness of the PBT film is preferably 20-100$\mu$m (more preferably, 30-75$\mu$m). If the thickness of the PBT film is less than 20$\mu$m, the heat shrinkage properties and rigidity of the film are insufficient, so handling properties are poor. On the other hand, if the thickness exceeds 100$\mu$m, film transparency decreases and manufacturing costs become much higher.

The PVDF which forms the PVDF film 14 may be a homopolymer of vinylidene fluoride. The PVDF may be a single polymer of vinylidene fluoride or a copolymer of vinylidene fluoride with another polymerizable monomer known in the art, but its polymerization degree is preferably 1000-3000, e.g., KF#850, KF#1000, KF#1100 (commercial names, Kureha Chemical Industries Ltd.).

The thickness of the PVDF film 14 is preferably 1-10$\mu$m (more preferably 3-6$\mu$m). If the thickness of the PVDF film 14 is less than 1$\mu$m, wear and abrasion resistance are inferior, and it is difficult to make the thickness uniform. On the other hand, if it is greater than 10$\mu$m, electrical properties tend to decline, and since PVDF is expensive, manufacturing costs sharply increase. Additionally, by arranging the thickness of the PVDF film 14 to lie within the aforesaid optimum range, when it is used as a member of the electronic component described later, an electronic component having increased electrical capacity, sensitivity, response speed and resolution is obtained.

The peel strength of the laminated film 10 is 1-80g/25mm width. If the peel strength is less than 1g/25mm, the PBT film 12 and PVDF film 14 which form the laminated film 10 peel away from each other too easily, and the PVDF film 14 is easily damaged. On the other hand, if it exceeds 80g/25mm width, too much force is used when peeling the PBT film 12 away from the laminated film 10, so the PVDF film 14 may be damaged.

Also, according to the present invention, the elastic moduli in the length direction and width direction of the laminated film 10 derived from the formula (1) are preferably -2 to +2% respectively (if the electrode interval of the electronic component is narrow, more preferably - 1.0 to +1.0%), but depending on the dimensional precision of the electronic component, a smaller elastic modulus may be called for. If the elastic modulus is outside the aforesaid optimum range, the laminated film 10 curls easily, and it is difficult to ensure dimensional stability. When the value of the elastic modulus is minus (-), it means that the laminated film 10 has contracted, and when it is plus (+), it means that the laminated film 10 has extended.

To reduce the peel strength of the PBT film 12 and PVDF film 14 and further enhance the peeling properties of the laminated film 10, a release agent layer may be formed between the PBT film 12 and PVDF film 14. The release agent forming the release agent layer may be a higher fatty acid or its metal salt (calcium stearate, etc.).

The laminated film 10 from which the thin polyvinylidene fluoride film is obtained, satisfies the following 8 criteria for manufacture, storage and use.

1) The laminated film 10 has good peeling properties.
2) The laminated film 10 does not curl easily.
3) The laminated film 10 has excellent dimensional stability.
4) The laminated film 10 has heat resistance.
5) The laminated film 10 has excellent transparency.
6) The laminated film 10 is non-hygroscopic (non-moisture absorbing).
7) The laminated film 10 has excellent handling properties.

8) The laminated film 10 is glossy.

It appears that 1) is due to the specific material of the laminated film 10, and the fact that the peel strength of the PBT film 12 and PVDF film 14 lies within specific limits. It further appears that 2) and 3) are due to the specific material of the laminated film 10, and the fact that it is unoriented. In a process for manufacturing an actual electronic component, it is desired that in a heating step after forming a circuit by screen printing on the laminated film 10 of for example 600mm width, the heating elasticity of the laminated film 10 is within -2% to +2% to prevent offset of circuit dimensions, and the laminated film 10 has this performance. Factors for obtaining this effect are that the hygroscopicity of the PBT film 12 is low, the PBT film 12 has excellent heat resistance and it is sufficiently thick. If the hygroscopicity of the PBT film 12 is low, it will not be easily affected by humidity during manufacture or storage of the laminated film 10. Also, in the step for manufacturing the electronic component using the laminated film 10, it is desired to maintain the shape of the film when it is heated at, for example, 100°C for 60 mins and 150°C for 15 mins, and PBT has the performance to satisfy this requirement.

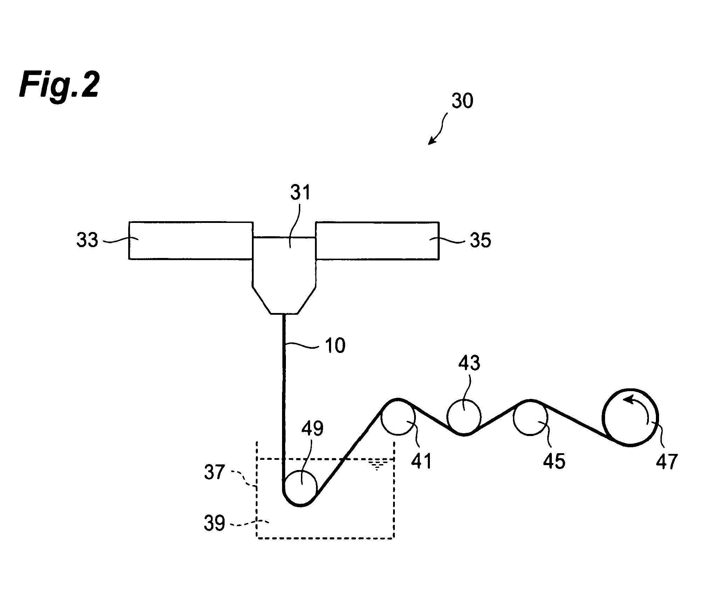

Hereafter, a suitable method of manufacturing the laminated film 10 using the manufacturing device 30 of FIG. 2, will be described. First, according to this method, molten PBT and PVDF are co-extruded by first and second extruders 33, 35, and stuck together in a dice 31 to form the laminated film 10 (laminated film-forming step). Next, the film is wound on a roller 47, while cooling the obtained laminated film 10 with first-third cooling rollers 41, 43, 45 (winding step). In this case, the film is wound on the roller 47 without extending the laminated film 10 paid out from the dice 31. Hence, a unoriented laminated film comprising the polyvinylidene fluoride film laminated on the polybutylene terephthalate film, is obtained. A lead pipe (not shown) which can be warmed is provided between the dice 31 and the first-second extruders 33, 35. This makes it possible to introduce the molten PBT and PVDF extruded by the extruders 33, 35 into the dice 31. The construction of the first-third cooling rollers 41, 43, 45 is also such that they can be warmed.

In order to make the polyvinylidene fluoride a thin film, the following are used for the cylinder diameter and screw L/D ratio of the extruders 33, 35. The first extruder 33 has a cylinder diameter of for example 65-120mm and screw L/D ratio of 24-32, whereas the second extruder 35 has a cylinder diameter of for example 30-80mm and screw L/D ratio of 24-28. The preset temperature range of the extruder 33 is preferably 200-270°C, but more preferably 200-250°C or 210-270°C, and the preset temperature range of the extruder 35 is preferably 230-270°C, but more preferably 230-260°C or 230-270°C.

The dice 31 may be for example a T die, or a multi-manifold type two-layer T die. When using a two layer T die under the aforesaid extrusion conditions, the flow velocities when molten PVDF and PBT flow into the dice together are equal when the flowrates of the respective resins are in the ratio former:latter =1:11.7.

According to this manufacturing method, the laminated film 10 comprising the thin PVDF film 14 on the PBT film 12 can be obtained easily by co-extrusion. Since the laminated film 10 has peeling properties, a polyvinylidene fluoride thin film with suppressed curl can be provided.

The laminated film 10 can also be manufactured by adding a cooling bath 37 shown by the dotted line of FIG. 2 to the previous construction. In addition to the previous construction, the manufacturing device provides the cooling bath 37 directly under the dice 31. In the method of manufacturing the laminated film 10 using this manufacturing device, molten PVDF and PBT are co-extruded to form the laminated film 10 inside the dice 31 (laminated film-forming step), and the laminated film 10 is then brought in contact with a medium having a temperature in the vicinity of the glass transition point of PBT, and rapidly cooled (cooling step). In this cooling step, the laminated film 10 is impregnated by the cooling bath 37 provided directly under the dice 31 so that it is rapidly cooled. Next, the obtained laminated film 10 is wound around the roller 47, while cooling by the first-third cooling rollers 41, 43, 45 (winding step). In this case, it is wound around the roller 47 without extending the laminated film 10 paid out from the dice 31.

The cooling bath 37 provided directly under the dice 31 is filled with a medium 39 such as for example warm water or glycerin. This medium 39 is kept at 10-90°C in order to maintain the transparency of the laminated film.

In the aforesaid cooling step, as the laminated film 10 is rapidly cooled by the cooling bath 37 provided directly under the dice 31, curl of the laminated film 10 is suppressed even more, and the film has excellent dimensional stability. The factors responsible for this effect are not clear, but it appears that the rapid cooling permits the elasticity of the film to be suppressed.

In the aforesaid manufacturing method, when the molten PBT and PVDF are co-extruded and stuck together in the dice 31, a step may be provided for adding a release agent such as calcium stearate, and forming a release agent layer between the PBT film 12 and PVDF film 14.

(Electronic component)

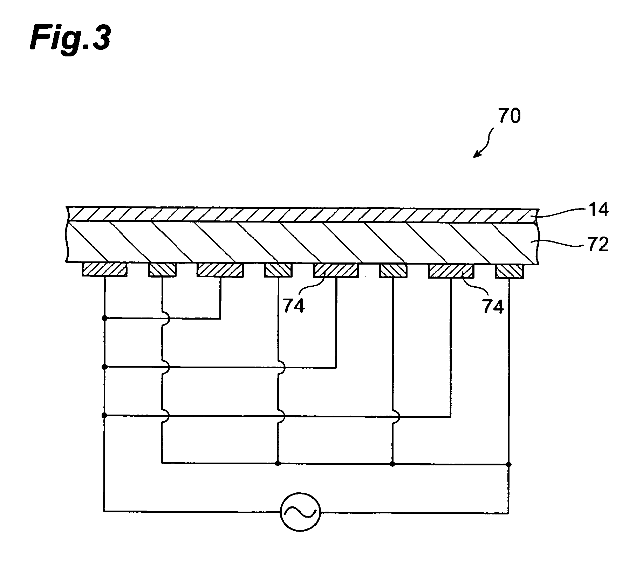

FIG. 3 is a cross-sectional view showing an electronic component relating to this embodiment. An electronic component 70 relating to this embodiment comprises a flat substrate 72, a film layer 14 of PVDF film, and plural electrodes 74. The film layer 14 is formed on the top surface (one of the main surfaces) of the substrate 72. The electrodes 74 are formed on the undersurface (the other main surface) of the substrate 72.

The electronic component 70 may for example be a self-emitting optical display such as an EL light-emitting board. When the electronic component 70 is an EL light-emitting board, the substrate 72 may be for example a light-emitting body. The light-emitting body comprises a parent material of an inorganic fluorescent substance/light-emitting center of ZnS/Mn, CaS/Eu or the like microencapsulated in an alumina coating, and dispersed in a polysaccharide such cyanoethyl pullulan. The electrodes 74 are a metal such as copper, aluminum, silver paste or ITO (transparent electrodes). The film layer 14 is the PVDF thin film obtained by peeling the PBT film 12 away from the laminated film 10.

This electronic component 70 has a high specific inductance, and as it comprises the PVDF thin film 14, a large electrostatic capacity is obtained together with excellent sensitivity. The film layer 14 has no cloudiness, has excellent transparency and also gloss, so if a light-emitting body is used as the substrate 72, the electronic component 70 will have a high luminosity.

(Method of manufacturing electronic component)

Next, the method of manufacturing the electronic component relating to this embodiment will be described. First, on the laminated film 10, the substrate 72 is formed so that one of its main surfaces comes in contact with the PVDF thin film 14. In other words, the substrate 72 is formed on the PVDF film 14 of this laminated film 10. The substrate 72 may be formed by for example screen printing, application with a coater or a photographic method. Next, plural electrodes 74 are formed on the other main surface of the substrate 72. Specifically, the plural electrodes 74 are formed on the undersurface of the substrate 72 whereupon the PVDF film was formed. The electrodes 74 can be formed by the photographic method or the screen-printing method. The PBT film 12 is then peeled away from the laminated film on which the substrate and electrodes were formed. In this way, the electronic component 70 having a thin film layer 14 of a PVDF film on one of the main surface (top surface) of the substrate 72, can be manufactured.

Prior art electronic components were manufactured by laminating a PVDF film peeled away from a laminated film on a top surface (a main surface) of a substrate, and forming electrodes on both the PVDF film and the exposed surface of the substrate. On the other hand, the method of manufacturing the electronic component 70 of the present embodiment of the invention uses the laminated film 10 without peeling away the PVDF film 14. After forming the electrodes 74 on one surface (the other main surface) of the substrate 72, the PBT film 12 is then peeled away from the laminated film 10. According to this method, manufacturing steps can be simplified, soiling or damage of the PVDF film 14 is prevented, and the electronic component 70 can be manufactured easily.

EXAMPLES

[Manufacture of laminated film]

[Example 1]

Polybutylene terephthalate (hereafter, "PBT") was supplied to a first extruder (cylinder diameter 90mm, screw L/D=28), and the melted PBT was made to flow into a two-layer T die at a temperature of 200-270°C and an extrusion amount of 1430g/min. At the same time, polyvinylidene fluoride (hereafter, "PVDF") was supplied to a second extruder (cylinder diameter 40mm, screw L/D=25), and the melted PVDF was made to flow into the T die at a temperature of 230-270°C and an extrusion amount of 180g/min. The PVDF was KF#1000 (commercial name, polymerization degree 1000, Kureha Chemical Industries Ltd.), and the PBT was Gelanex 700FP (commercial name, Polyplastics Ltd.).

Next, the molten PVDF and PBT were mixed together in front of the lip of the two-layer T die to form a laminated film. The two-layer T die was a multi-manifold type of width 1700mm, and the lip clearance was 0.6 mm.

Next, the obtained laminated film was immersed in a cooling warm water tank (cooling bath) wherein the water temperature was adjusted to 70°C. The laminated film was then passed to a first cooling roller (adjusted to 80°C), a second cooling roller (adjusted to 80°C) and a third cooling roller (adjusted to 70°C), and wound on a winding roller at a speed of 8.8m/min without extension. The thickness of the obtained unoriented laminated film was 60μm. The thickness of the PVDF film was 5μm, and the thickness of the PBT film was 55μm.

(Example 2)

A laminated film was manufactured by an identical method to that of Example 1, except that the laminated film was not passed through the cooling bath, and the thickness of the laminated film was 70μm (thickness of PVDF film/ thickness of PBT film= 5μm /65μm).

(Comparative Example 1)

A laminated film was manufactured by an identical method to that of Example 1, except that polymethyl methacrylate (PMMA) was used instead of PBT.

[Laminated film property tests]

To examine the properties of the laminated film obtained in Examples 1-2 and Comparative Example 1, a curl test was performed, and elastic modulus, peel strength, haze, transparency and gloss were measured by the following methods.

[Curl]

A test piece was cut out to a square shape of side 100mm from the laminated films obtained in Examples 1-2 and Comparative Example 1. Next, an "X"-shaped cut was made in this test piece along the diagonals. The test piece with this cut was left on a flat surface, the cut part was observed, and the degree of curl (degree of raising of the film) was evaluated according to the following criteria. Table 1 shows the test results.

Evaluation criteria:

A: Curl did not occur in the cut part of the test piece.
B: Curl did occur in the cut part of the test piece, but the angle between the raised part of the curl and the surface on which the piece was placed, was less than 90 degrees.
C: Curl did occur in the cut part of the test piece. The angle between the raised part of the curl and the surface on which the piece was placed, was 90 degrees or more.
D: Curl did occur in the cut part of the test piece, and the film rolled up.

[Elastic modulus]

Elastic modulus was measured as follows based on JIS K6734, 6.6. First, a test piece having a square shape of side 120 mm was cut out of the laminated film. Next, the test piece was placed horizontally in a hot air recirculation oven maintained at a temperature of $100\pm2°C$ for 10 mins, and cooled to room temperature. Next, the length of the test piece in the length direction (MD) and width direction (TD) was measured. The measured values were substituted in the following equation, and the elastic modulus in the length direction and width direction were calculated. Table 1 shows the measurement results.

$$S(\%)=(L_2-L_1)/L_1 \times 100$$

[in the equation, S is the elastic modulus, and $L_1$ is 100mm which is the distance (mm) between reference points prior to heating. $L_2$ is the distance (mm) between reference points after heating under $100\pm2°C$ for 10 min].

[Peel strength]

The peel strength was measured by performing the following T type peel test based on JIS K6854. First, a test piece of width 25mm was cut out of the laminated film. Next, both ends of this test piece were attached to the grips of a universal tension test meter (Toyo Precision Instruments Ltd.). Next, the interface of the test piece was peeled away from the ends of the test piece when the motion speed of the crosshead (elastic stress rate) was $100\pm5$mm/min. The tensile force between the PBT film and PVDF film at this time was measured, and taken as the peel strength. Table 1 shows the measurement results.

[Haze and degree of transparency]

To evaluate the transparency, the haze (clouding) and degree of transparency (total degree of transparency to light) were measured. The measurement was performed using an automatic haze meter (Nippon Densyoku Kogyo) based on JIS K7105. Table 1 shows the measurement results.

[Gloss]

Gloss was measured using a gloss checker IG320 (Horiba, Ltd.) based on JIS K7105. Table 1 shows the measurement results.

[Table 1]

| | Presence or absence of cooling bath | Physical properties of laminated film for peeling | | | | | | |
|---|---|---|---|---|---|---|---|---|
| | | Thickness ($\mu$m) (PVDF/PBT) | Interlayer peeling force (g/ 25mm width) | Curl | Heating elastic modulus (MD/TD, %) | Haze (%) | Degree of transparency (%) | Gloss (%) |
| Ex. 1 | Present | 5/55 | 76 | A | -0.8/-0.6 | 4 | 90.4 | 84 |
| Ex. 2 | absence | 5/65 | 95 | A | -0.6/+0.2 | 15.9 | 83.5 | 55 |
| Comp. Ex. | Present | 5/55 | Peeling not possible | A | -1.0/+0.2 | 4.2 | 90.3 | 120 |

[Manufacture of electronic component]

(Example 3)

An EL light-emitting board was manufactured by the following method using the laminated film obtained in Example 1. First, a laminated film of size 100mm x 150mm (postcard size) was fixed in a device so that the PBT film was the lower layer and PVDF film was the upper layer, and an EL light-emitting layer was formed by thick film screen printing on the PVDF film. The EL light-emitting layer was a material comprising a parent material/light-emitting center of ZnS/Mn microencapsulated in an alumina coating, dispersed in cyanoethyl pullulan.
Next, silver paste electrodes were formed by silver paste screen printing so that comb-shaped anodes and cathodes were arranged alternately at an interval of 3mm on the EL light-emitting layer. Polyurethane resin was coated thereupon as a coating layer. Next, the laminated body thus obtained was inverted, and the PBT film in the uppermost part was peeled off with cellotape to obtain the EL light-emitting board. The peeling of the PBT film from the PVDF layer of the laminated body was satisfactory.
When the anodes and cathodes of the obtained EL light-emitting board were connected by leads, and shapes and characters were drawn on the exposed surface of the PVDF film by a transparent water-based pen (containing a dispersing agent ink) while applying an AC voltage of approximately 300V (400Hz), only the parts drawn by the pen conducted electricity and emitted light. Even when characters were drawn repeatedly on the exposed surface of the PVDF film layer, only the parts drawn by the pen emitted light.
From this fact, it was found that by using the aforesaid laminated film as an EL light-emitting board back film, the process of manufacturing the EL light-emitting board was simplified, and stable performance was obtained.
The present invention therefore provides a laminated film for obtaining a polyvinylidene fluoride thin film suitable for use in electronic components which is easy to handle, which has excellent dimensional stability and heat resistance, and which is also transparent, glossy, non-hygroscopic and curl-resistant. The present invention further provides a polyvinylidene fluoride thin film which can be obtained by peeling away from this laminated film, a method of manufacturing same, an electronic component comprising this polyvinylidene fluoride thin film, and a method of manufacturing same.

**Claims**

1. A laminated film comprising a polyvinylidene fluoride film laminated on a polybutylene terephthalate film such that it can be peeled away, wherein:

   said laminated film is unoriented, and the peel strength of said polybutylene terephthalate film and said polyvinylidene fluoride film is 1-80g/25 mm width.

**2.** A polyvinylidene fluoride film obtained by peeling away from the laminated film according to Claim 1.

**3.** A method of manufacturing a polyvinylidene fluoride film wherein molten polybutylene terephthalate and polyvinylidene fluoride are co-extruded to obtain an unoriented film, the polyvinylidene fluoride film being laminated on the polybutylene terephthalate film such that it can be peeled away, and the polybutylene terephthalate film is then peeled away from the laminated unoriented film.

**4.** An electronic component comprising a substrate, a unoriented film layer laminated on one of the main surfaces of said substrate and plural electrodes formed at a predetermined interval on the other main surface of said substrate, wherein:

said film layer is the polyvinylidene fluoride film according to Claim 2.

**5.** A method of manufacturing an electronic component comprising a substrate, a unoriented film layer laminated on one of the main surfaces of said substrate and plural electrodes formed at a predetermined interval on the other main surface of said substrate, said method comprising the steps of:

forming said substrate so that one of the main surfaces on which a film is to be formed is in contact with polyvinylidene fluoride on the laminated film according to Claim 1,
forming plural electrodes on the other main surface of said substrate, and
peeling a polybutylene terephthalate film away from said substrate and the laminated film on which said electrodes are formed.

**Patentansprüche**

**1.** Folienlaminat, umfassend eine Polyvinylidenfluorid-Folie, die auf eine Polybutylenterephthalat-Folie derart auflaminiert ist, dass sie abgezogen werden kann, wobei:

das Folienlaminat nicht-orientiert ist und die Abziehfestigkeit der Polybutylenterephthalat-Folie und der Polvinylidenfluorid-Folie 1 bis 80 g/25 mm Breite beträgt.

**2.** Polyvinylidenfluorid-Folie, erhalten durch Abziehen von dem Folienlaminat gemäß Anspruch 1.

**3.** Verfahren zur Herstellung einer Polyvinylidenfluorid-Folie, wobei geschmolzenes Polybutylenterephthalat und Polyvinylidenfluorid co-extrudiert werden, um eine nicht-orientierte Folie zu erhalten, bei der die Polyvinylidenfluorid-Folie derart auf die Polybutylenterephthalat-Folie laminiert ist, dass sie abgezogen werden kann, und die Polybutylenterephthalat-Folie dann von dem nicht-orientierten Folienlaminat abgezogen wird.

**4.** Elektronisches Bauteil umfassend ein Substrat, eine nicht-orientierte Folienschicht, die auf eine der Hauptoberflächen des Substrats auflaminiert ist, und eine Vielzahl von Elektroden, ausgebildet in einem vorbestimmten Intervall auf der anderen Hauptoberfläche des Substrats, wobei:

die Folienschicht eine Polyvinylidenfluorid-Folie gemäß Anspruch 2 ist.

**5.** Verfahren zur Herstellung eines elektronischen Bauteils umfassend ein Substrat, eine nicht-orientierte Folienschicht, laminiert auf eine der Hauptoberflächen des Substrats, und eine Vielzahl von Elektroden, ausgebildet in einem vorbestimmten Intervall auf der anderen Hauptoberfläche des Substrats, wobei das Verfahren die folgenden Schritte umfasst:

Ausbilden des Substrats derart, dass eine der Hauptoberflächen, auf welcher die Folie ausgebildet werden soll, in Kontakt mit dem Polyvinylidenfluorid auf dem Folienlaminat gemäß Anspruch 1 ist,
Ausbilden einer Vielzahl von Elektroden auf der anderen Hauptoberfläche des Substrats, und
Abziehen eines Polybutylenterephthalat-Films von dem Substrat und dem Folienlaminat, auf denen die Elektroden ausgebildet sind.

**Revendications**

1. Film lamifié comprenant un film de poly(fluorure de vinylidène) lamifié sur un film de poly(téréphtalate de butylène), de telle sorte qu'il peut être enlevé par pelage, dans lequel:

   le film lamifié est non orienté, et la résistance au pelage du film de poly(téréphtalate de butylène) et du film de poly(fluorure de vinylidène) est de 1-80 g/25 mm de largeur.

2. Film de poly(fluorure de vinylidène) obtenu par pelage du film lamifié selon la revendication 1.

3. Procédé de fabrication d'un film de poly(fluorure de vinylidène), dans lequel du poly(téréphtalate de butylène) et du poly(fluorure de vinylidène) à l'état fondu sont co-extrudés pour obtenir un film non orienté, le film de poly(fluorure de vinylidène) étant lamifié sur le film de poly(téréphtalate de butylène) de telle sorte qu'il peut être enlevé par pelage, et le film de poly(téréphtalate de butylène) étant ensuite enlevé par pelage du film lamifié non orienté.

4. Composant électronique comprenant un substrat, une couche d'un film non orienté lamifié sur l'une des surfaces principales du substrat, et plusieurs électrodes formées à un intervalle prédéterminé sur l'autre surface principale du substrat, dans lequel:

   la couche de film est un film de poly(fluorure de vinylidène) selon la revendication 2.

5. Procédé de fabrication d'un composant électronique comprenant un substrat, une couche d'un film non orienté lamifié sur l'une des surfaces principales du substrat, et plusieurs électrodes formées à un intervalle prédéterminé sur l'autre surface principale du substrat, le procédé comprenant les étapes consistant à:

   former le substrat de telle sorte que l'une des surfaces principales sur laquelle doit être formé un film est en contact avec le poly(fluorure de vinylidène) du film lamifié selon la revendication 1,
   former les plusieurs électrodes sur l'autre surface principale du substrat, et
   enlever par pelage un film de poly(téréphtalate de butylène) du substrat et du film lamifié sur lequel sont formées les électrodes.

*Fig.1*

10

14

12

**Fig.2**

EP 1 731 305 B1

*Fig.3*

**EP 1 731 305 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 60006220 B
- JP SHO6054832 A
- JP 57156224 A
- JP 61123520 A
- JP 1198636 A
- JP 63243143 A
- US 4302408 A